# EUROPÄISCHE PATENTSCHRIFT

(11) **EP 1 550 215 B1**
(45) Veröffentlichungstag und Bekanntmachung des Hinweises auf die Patenterteilung: **19.03.2008**
(21) Anmeldenummer: 03769197.9
(22) Anmeldetag: 17.09.2003
(51) Int. Cl.: H03K 17/082

(54) **VERFAHREN UND VORRICHTUNG ZUR BETÄTIGUNG EINES LEISTUNGSSCHALTERS**
METHOD AND DEVICE FOR ACTUATING A POWER CIRCUIT BREAKER
PROCEDE ET DISPOSITIF DE COMMANDE D'UN DISJONCTEUR

(30) Priorität: 09.10.2002 DE 10247111
(43) Veröffentlichungstag der Anmeldung: 06.07.2005
(73) Patentinhaber: SIEMENS AKTIENGESELLSCHAFT, 80506 München (DE)
(72) Erfinder: BOLZ, Stephan, 93102 Pfatter (DE); KNORR, Rainer, 93055 Regensburg (DE); LUGERT, Günter, 93055 Regensburg (DE)
(86) Internationale Anmeldenummer: PCT/DE2003/003090
(87) Internationale Veröffentlichungsnummer: WO 2004/034584

(56) Entgegenhaltungen:
- EP-A- 1 028 467
- DE-A- 19 548 612
- US-A- 5 291 387
- US-A- 6 005 761
- US-A1- 2002 021 539

## Beschreibung

Die Erfindung betrifft ein Verfahren zur Betätigung eines Leistungsschalters nach dem Oberbegriff von Anspruch 1, insbesondere eines zwischen zwei Energiespeichern angeordneten Halbleiter-Leistungsschalters in einem mit einem Integrierten Starter-Generator ausgerüsteten Kraftfahrzeug-Bordnetz. Sie betrifft auch eine Vorrichtung zur Durchführung dieses Verfahrens nach Anspruch 2.

Im einem Kraftfahrzeug-Bordnetz mit ISG sind Schaltvorgänge zwischen Energiespeichern - Akkumulatoren verschiedener Nennspannungen und Kondensatoren (Zwischenkreiskondensatoren, Doppelschichtkondensatoren) - über Umrichter oder Schaltregler mittels Leistungsschaltern erforderlich, die mittels der Befehle eines Steuergeräts durchgeführt werden.

Bedingung dabei ist, dass vor dem Öffnen eines Schalters der durch ihn fließende Schalterstrom auf 0A gebracht wird, und dass vor dem Schließen eines Schalters die zwischen seinen Schaltkontakten liegende Schalterspannung auf 0V gebracht wird, damit der Schalter leistungsfrei betätigt werden kann.

Ein Schalterstrom 0A kann beispielsweise durch Abschalten von AC/DC-Umrichter oder DC/DC-Schaltregler erfolgen und stellt in der Praxis kein Problem dar.

Die Regelung auf 0V Schalterspannung, d.h., keine Potentialdifferenz zwischen den Polen des (geöffneten = nicht leitenden) Schalters, erfolgt in der Regel durch gezieltes Umladen eines der Energiespeicher, beispielsweise eines Zwischenkreiskondensators, da dieser in der Regel der kleinere der Energiespeicher ist. Diese Regelung kann auch prinzipiell durch einen Umrichter oder einen zwischen diesem und dem Bordnetz befindlichen Schaltregler erfolgen.

Der Zwischenkreiskondensator hat beispielsweise eine Kapazität von mehreren 10.000µF, der Doppelschichtkondensator beispielsweise eine Kapazität von 200F, die Akkumulatoren eine Kapazität von mehreren Ah. Die auszugleichende Schalterspannung kann bis zu 60V betragen.

Bedingt durch das ungünstige Verhältnis von Leistungsfähigkeit von Umrichter (z.B. 6kW) oder Schaltregler (z.B. 1kW) zu der für den Ladungsausgleich (bis 40 Joule) erforderlichen Energie sind dem Spannungsausgleich jedoch in der Praxis enge Grenzen gesetzt.

Werden nun beispielsweise aus Gründen der Zuverlässigkeit und des Platzbedarfs als Schalter Halbleiterschalter eingesetzt, so reicht die so erzielbare Genauigkeit des Spannungsausgleichs nicht aus.

Im normalen Betrieb auftretende Ströme und Leistungen erfordern die Verwendung von Bauelementen (Kondensatoren, Schaltern) mit sehr kleinen Widerständen. Entsprechend hoch fallen bei vorhandenen Spannungsdifferenzen die Ausgleichsströme über dem zu schließenden Schalter aus. Im Extremfall führt dies zur Zerstörung der Halbleiter.

Eine Begrenzung des durch den Schalter fließenden Ausgleichsstromes auf einen ungefährlichen Wert setzt eine Strommessung voraus, die bei der Höhe der auftretenden Ströme einen kostenintensiven Stromsensor erfordert. Außerdem kann der Ausgleichsvorgang nicht zeitoptimiert verlaufen, da bei großer Schalterspannung die Verlustleistung im Schalter hoch ist, was eine weitere mögliche Begrenzung darstellt.

Es ist Aufgabe der Erfindung, ein Verfahren und eine entsprechende Vorrichtung zur Betätigung eines Halbleiter-Leistungsschalters zu schaffen, die ohne kostenintensiven Stromsensor auskommt und bei welcher der Einschaltvorgang und der Einschaltzustand so geregelt werden, dass auch bei großer Spannungsdifferenz am Schalter eine Beschädigung der Transistoren ausgeschlossen ist.

Diese Aufgabe wird erfindungsgemäß durch ein Verfahren gemäß den Merkmalen von Anspruch 1 und eine Vorrichtung gemäß den Merkmalen des Anspruchs 2 gelöst.

Es wird ein Verfahren und eine Vorrichtung zum Schalten eines Halbleiterleistungsschalters vorgeschlagen, die sich dadurch auszeichnen, dass der Widerstand der Schaltstrecke des Halbleiterleistungsschalters so geregelt wird, dass die Chiptemperatur des Halbleiter-Leistungsschalter eine vorgegebene Solltemperatur nicht übersteigt, hierbei wird bei Erreichen der vorgegebenen Solltemperatur der Widerstand der Schaltstrecke des Halbleiter-Leistungsschalters erhöht, wodurch zum einen die Verlustleistung sinkt und zum anderen auch bedingt durch die reduzierte Verlustleistung die Chiptemperatur abnimmt.

Vorteilhafte Weiterbildungen der Erfindung sind den Unteransprüchen zu entnehmen.

Das erfindungsgemäße Verfahren umfasst die technische Lehre, den Widerstand der Schaltstrecke des Halbleiter-Leistungsschalters mittels einer Steuerspannung so zu steuern, dass die Temperatur in des Leistungsschalters (Chiptemperatur) einen vorgegebenen Wert nicht übersteigt bzw. auf einen Konstantwert geregelt wird, wobei die Regelgröße als Steuersignal zur Erzeugung der Steuerspannung dient.

Bei einer Vorrichtung zur Durchführung dieses Verfahrens ist vorgesehen, den Schalter als Transfer-Gate mit speziellen Halbleiter-Transistoren auszubilden, in welche Dioden zur Erfassung der Chiptemperaturen integriert sind, und mittels einer Ladungspumpe so anzusteuern, dass die Chiptemperatur der Transistoren geregelt und auf einen vorgegebenen Sollwert begrenzt werden kann.

Vorteilhafterweise liegt die vorgegebene Solltemperatur im Bereich der Betriebstemperatur des Leistungshalbleiters. Dadurch wird zum einen verhindert, dass der Leistungsschalter oberhalb seiner zulässigen Betriebstemperatur betrieben wird und zum anderen bedingt durch einen solchen Betrieb die Lebensdauer des Leistungshalbleiters reduziert wird.

Vorteilhafte Weiterbildungen der Erfindung sind den Unteransprüchen zu entnehmen.

Ein Ausführungsbeispiel nach der Erfindung wird nachstehend anhand einer schematischen Zeichnung näher erläutert. In der Zeichnung zeigen:
- Figur 1: ein Prinzipschaltbild eines 14V/42V-Kraftfahrzeug-Bordnetzes,
- Figur 2: ein Prinzipschaltbild eines als Transfer-Gate ausgebildeten Halbleiter-Leistungsschalters,
- Figur 3: die Schaltung eines mittels einer Ladungspumpe ansteuerbaren Transfer-Gates,
- Figur 4: eine Temperaturerfassungseinheit mit Sollvergleich und logischer Verknüpfung.

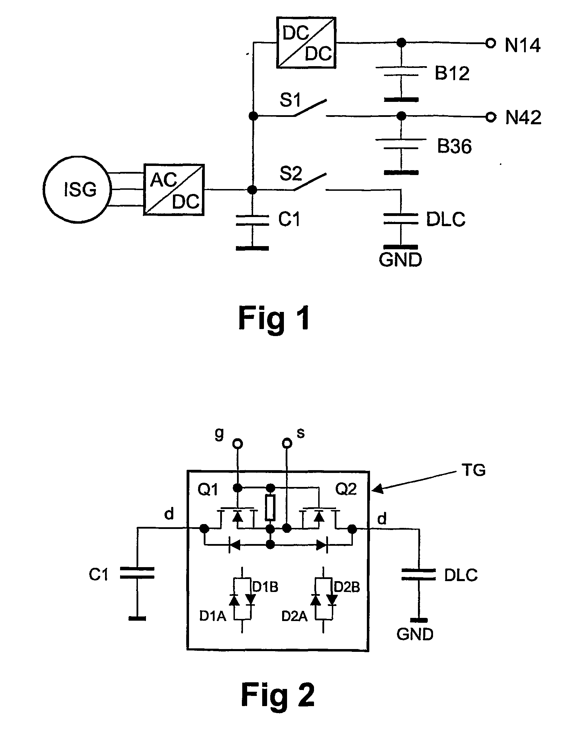

Figur 1 zeigt ein Prinzipschaltbild eines 14V/42V-Kraftfahrzeug-Bordnetzes mit einem mit einer nicht dargestellten Brennkraftmaschine gekoppelten integrierten Starter-Generator ISG, anhand dessen die Erfindung, näher erläutert wird.

Dieser ISG ist über einen bidirektionalen AC/DC-Wandler AC/DC
a) direkt mit einem Zwischenkreiskondensator C1,
b) über einen Leistungsschalter S2 mit einem Doppelschichtkondensator DLC,
c) über einen Leistungsschalter S1 mit einem 36V-Akkumulator B36 und einem 42V-Bordnetz, und
d) über einen bidirektionalen DC/DC-Wandler DC/DC mit einem 12V-Akkumulator B12 und einem 14V-Bordnetz N14
verbunden.

Erfindungsgemäß soll gemäß eines nicht näher erläuterten Programms jeder Leistungsschalter (S1 und S2) als Transfer-Gate ausgebildet sein und mittels der Befehle eines nicht dargestellten Steuergeräts von einer Ladungspumpe angesteuert werden.

Figur 2 zeigt ein Prinzipschaltbild für einen als Transfer-Gate TG ausgeführten Schalter, beispielsweise für den Schalter S2,der zwischen dem Zwischenkreiskondensator C1 und dem Doppelschichtkondensator DLC angeordnet ist. Falls weitere als Transfer-Gate ausgebildete Schalter erforderlich sind, so sind diese identisch ausgebildet.

Das Transfer-Gate TG besteht aus zwei in Reihe geschalteten MOSFET-Transistoren Q1 und Q2, deren Sourceanschlüsse s und Gateanschlüsse g jeweils miteinander verbunden sind. Die Drainanschlüsse d dienen als Eingang E oder Ausgang A des Schalters.

Da im Bordnetz die Spannungsdifferenzen und Stromrichtungen am Schalter beliebiges Vorzeichen bzw. beliebige Richtung haben können, ist die Verwendung von zwei in Reihe geschalteten Transistoren bzw. Transistorgruppen erforderlich, von denen im Sperrzustand des Leistungsschalters jeweils wenigstens einer sperrt. Eine derartige Anordnung ist als Transfer-Gate bekannt, welche die eigentliche Schaltfunktion ausübt.

Die Ansteuerung eines solchen als Transfer-Gate ausgebildeten Schalters erfolgt durch Anlegen einer Steuerspannung zwischen Source- und Gateanschluß. Zum Abbau dieser Steuerspannung ist ein in Figur 2 nicht näher bezeichneter Widerstand zwischen Gate- und Sourceanschluß vorgesehen.

Erfindungsgemäß ist vorgesehen, wie in Figur 2 angedeutet, im Transfer-Gate TG als Halbleiter Q1 und Q2 handelsübliche Transistoren mit integrierten Temperatursensoren (D1A, D1B, D2A und D2B) einzusetzen, die beispielsweise aus "Philips Semiconductors Product Specification, Power MOS transistor Voltage clamped logic level FET with temperature sensing diodes, BUK9120-48TC, February 1998" bekannt sind. Herstellerseitig sind zur Erfassung der Chiptemperaturen pro PowerMOSFET zwei antiparallele Dioden integriert, bei dem erfindungsgemäßen Ausführungsbeispiel wird jedoch nur jeweils eine Diode pro PowerMOSFET Q1, Q2 verwendet.

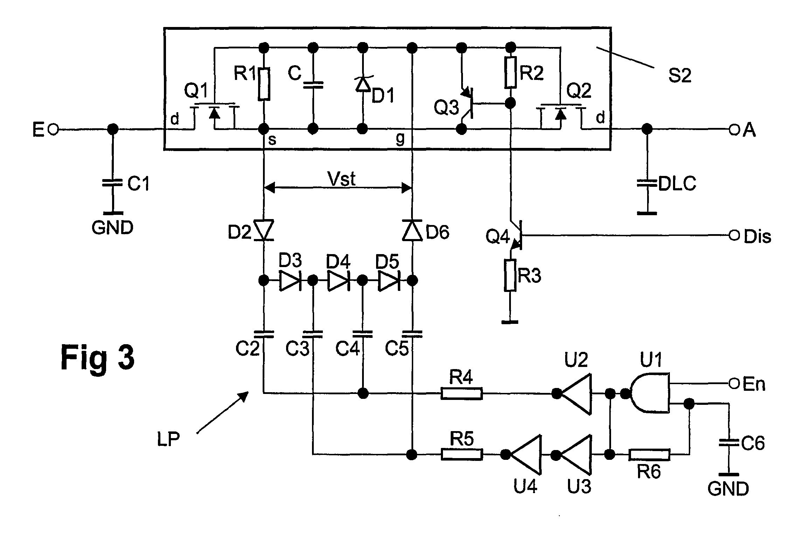

In Figur 3 ist die Schaltung des mittels einer Ladungspumpe ansteuerbaren, als Transfer-Gate ausgebildeten Schalters S2, der zwischen Zwischenkreiskondensator C1 und Doppelschichtkondensator DLC angeordnet ist, noch einmal, jedoch ohne die integrierten Temperatursensoren, dargestellt. Zusätzlich kann, mittels eines Signals Dis über einen weiteren, im Transfer-Gate angeordneten Transistor Q3 (und einen externen Transistor Q4) die Steuerspannung kurzgeschlossen werden, um das Transfer-Gate rasch zu öffnen (nichtleitend zu steuern).

Die an sich bekannte Ladungspumpe LP (Kondensatoren C2 bis C5 und Dioden D3 bis D5) baut eine Steuerspannung Vst zwischen Source- und Gateanschluß s, g des Transfer-Gates (Schalter 2) auf. Sie wird von einem Gatteroszillator (logische Schaltelemente U1 bis U4) mit Enablefunktion versorgt. So kann der Oszillator und mit ihm die Ladungspumpe LP durch ein logisches Steuersignal En (enable) ein- und ausgeschaltet werden. Die Erzeugung des Steuersignals En wird weiter unten erklärt.

Durch Einschalten der Ladungspumpe LP mittels des Signals En (En = High) wird zwischen Source- und Gateanschluß s, g eine positive Steuerspannung Vst aufgebaut, wodurch Schalter S2 (Transfer-Gate) entsprechend leitend wird. Nach dem Abschalten des Signals En (En = Low) wird diese Spannung über den Entladewiderstand R1 abgebaut, wodurch Schalter S2 wieder nichtleitend wird. Das Ein- und Ausschalten erfolgt zeitlich kontrolliert, d.h., durch gezieltes Ein- und Ausschalten der Ladungspumpe kann das Transfer-Gate in einem analogen Leitungszustand gehalten werden.

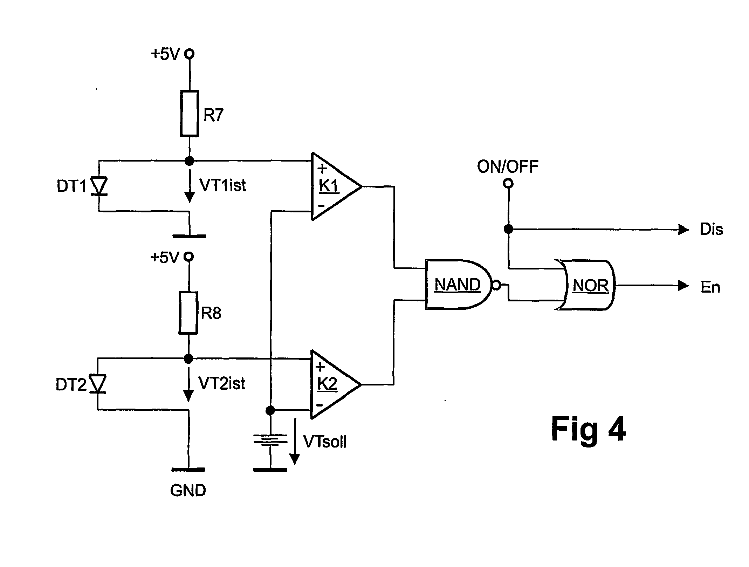

Figur 4 zeigt die erfindungsgemäße Schaltung zur Erfassung der Chiptemperaturen der Transistoren Q1 und Q2 des Transfer-Gates TG mit Sollvergleich und logischer Signal-Verknüpfung.

Diese Temperatur-Erfassungseinheit besteht für jeden Transistor Q1, Q2 aus einer an den Polen einer Spannungsquelle (die eine bereits vorhandene 5V-Versorgung sein kann) liegenden Reihenschaltung aus einem Widerstand R7, R8 und der temperatursensitiven Diode DT1, DT2 (welche der Diode D1B, D2B in Figur 2 entspricht), wodurch ein Arbeitsstrom von beispielsweise 1mA durch die Dioden DT1, DT2 fließt.

Der Verbindungspunkt zwischen Widerstand R7 und Diode DT1, bzw. Widerstand R8 und Diode DT2 ist jeweils mit dem nichtinvertierenden Eingang eines Komparators K1 bzw. K2 verbunden, an dessen invertierenden Eingang eine einer Solltemperatur Tsoll zugeordnete Sollspannung VTsoll liegt. Die Ausgänge der beiden Komparatoren K1, K2 sind mit den Eingängen eines ersten Logik-Gliedes NAND verbunden, dessen Ausgang mit einem Eingang eines zweiten Logik-Gliedes NOR verbunden ist, dessen anderem Eingang ein ON/OFF-Signal zugeführt wird, auf welches weiter unten eingegangen wird. Am Ausgang des zweiten Logik-Gliedes NOR erscheint das Steuersignal En, welches dem Gatteroszillator der Ladungspumpe LP zugeführt wird.

Die Dioden DT1, DT2 zur Erfassung der Chiptemperaturen haben einen negativen Temperaturkoeffizienten, d.h., bei steigender Chiptemperatur sinkt die Flussspannung mit ca. 1.6mV/°C monoton ab. Der Wert der Flussspannung bei 25°C beträgt beispielsweise 660mV.

Bedingt durch den Aufbau des Transfer-Gates wird jeweils ein Transistor verpolt betrieben (Drain-Source-Spannung), wohingegen der andere den wesentlichen Teil der Schalterspannung trägt. Entsprechend unterschiedlich entwickeln sich auch die Chiptemperaturen während eines Einschaltvorgangs. Es ist also erforderlich, die Temperaturen der Transistoren Q1, Q2 getrennt zu erfassen und die Regelung an der jeweils höheren Temperatur auszurichten.

Den nachstehenden Tabellen ist folgendes zu entnehmen (wobei High = H und Low = L; ein unterstrichenes Bezugszeichen bedeutet, dass das Signal an dessen Ausgang gemeint ist) :

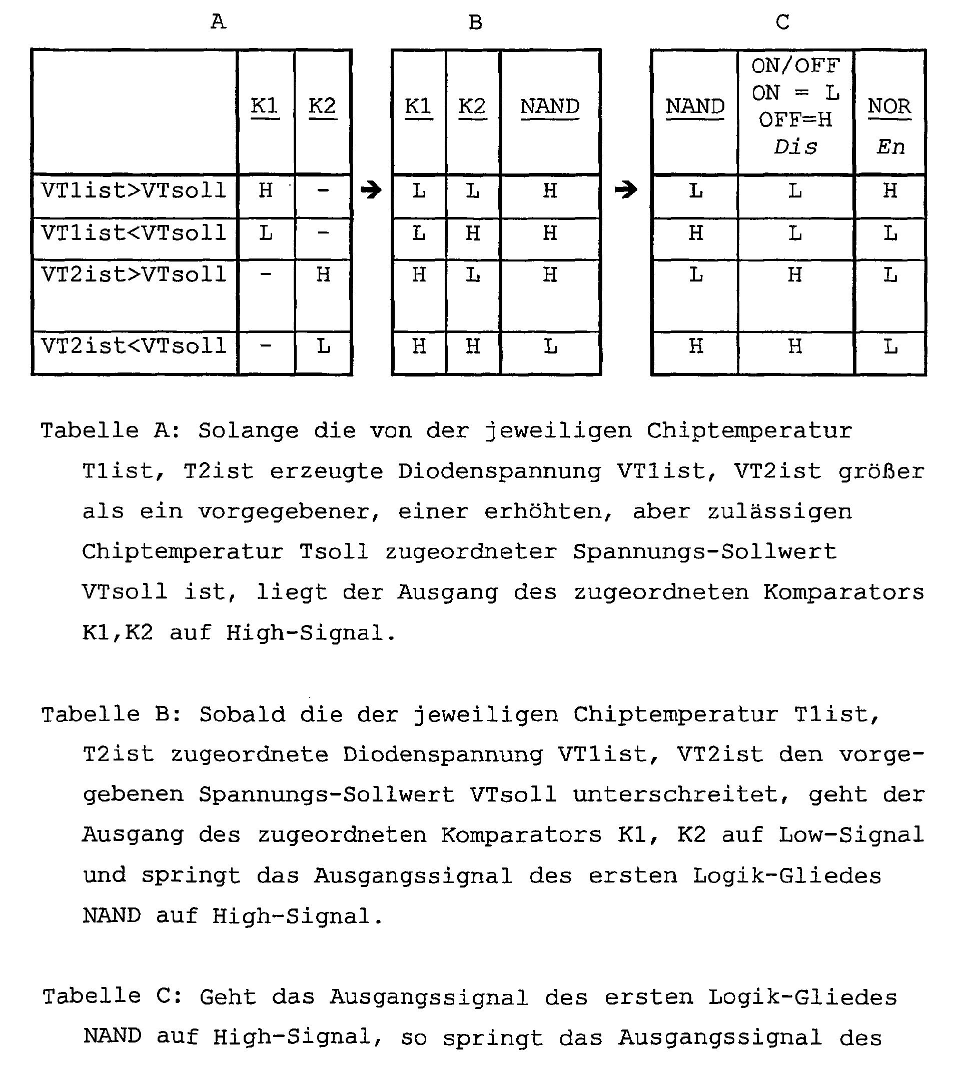

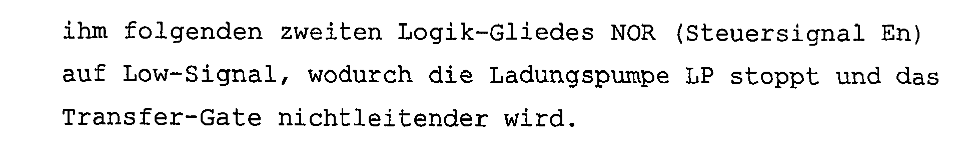

Aus Figur 4 und Tabelle C ist ein Signal ON/OFF entnehmbar. Dieses bereits erwähnte Signal ist ein Befehl des nicht dargestellten Steuergeräts. Es ist immer dann ON = Low, wenn der zugehörige Schalter S1, S2 leitend sein soll, und ist OFF = High, wenn dieser Schalter nichtleitend sein soll.

Dieses Signal ON/OFF ist identisch mit dem Signal Dis in Figur 3, welches den Schalter S1, S2 durch Kurzschließen der Gate-Source-Strecke rasch nichtleitend steuert und in diesem Betriebszustand hält, solange es OFF = High ist.

Aus Tabelle C ist also ersichtlich, dass die Ladungspumpe LP den Schalter nur dann leitend steuern kann, wenn einerseits das Steuergerät dazu die Erlaubnis gibt (ON = Dis = Low) und wenn andererseits das Ausgangssignal des Erste Logik-Gliedes NAND durch seinen Low-Zustand signalisiert, dass keine Chiptemperatur den Sollwert überschritten hat. Dann geht das Ausgangssignal En des zweiten Logik-Gliedes NOR auf High-Level und der nachfolgende Gatter-Oszillator (U1 bis U4, Figur 3) erzeugt eine steigende Gatespannung für das Transfer-Gate Q1, Q2, welches zusehends stärker leitet. Dadurch steigt der Strom durch Q1, Q2 und damit auch die Verlustleistung und die Chiptemperatur, woraufhin die Flussspannung der temperatursensitiven Dioden DT1 und DT2 sinkt. Dies geht solange, bis VT1ist oder VT2ist den Wert VTsoll unterschreitet. Steuersignal En geht auf Low und der Oszillator stoppt. Die Ladungspumpe LP liefert keine Gatespannung = Steuerspannung Vst mehr, und durch den Widerstand R1 entlädt sich Kondensator C1, wodurch die Gatespannung langsam abfällt. Das Transfer-Gate wird nichtleitender, die Verlustleistungen der Transistoren Q1 und Q2 sinken und damit auch die Chiptemperaturen, woraufhin die Flussspannungen der Dioden DT1 und DT2 wieder steigen und der Vorgang von neuem beginnt.

Insgesamt ist damit ein Zweipunktregler entstanden, dessen Oszillatorfrequenz und -amplitude von den Verzögerungszeiten der Regelelemente abhängen.

## Patentansprüche

1. Verfahren zum Schalten eines Halbleiter-Leistungsschalters (S1, S2),
**dadurch gekennzeichnet,**
**dass** der Widerstand der Schaltstrecke (E-A) des Halbleiter-Leistungsschalters (S1, S2) über einen Steuereingang (s, g) mittels einer Steuerspannung (Vst) und/oder eines Steuerstroms abhängig von der Chiptemperatur (T1ist, T2ist) so geregelt wird, dass die Chiptemperatur (T1ist, T2ist) des Leistungsschalters (S1, S2) eine vorgegebene Solltemperatur (Tsoll) beibehält, wobei bei Erreichen der Solltemperatur (Tsoll) der Widerstand der Schaltstrecke (E-A) erhöht wird.

2. Vorrichtung zur Durchführung des Verfahrens nach Anspruch 1, insbesondere zum Schalten eines zwischen zwei Energiespeichern (C1, DLC, B36) angeordneten Halbleiter-Leistungsschalters (S1, S2) in einem mit einem Integrierten-Starter-Generator (ISG) ausgerüsteten Kraftfahrzeug-Bordnetz, wobei der mittels einer Steuerspannung (Vst) leitend oder nichtleitend steuerbare Leistungsschalter (S1, S2) als Transfer-Gate (TG) ausgebildet ist,
- welches zwei in Reihe geschaltete Transistoren (Q1, Q2) oder Transistorgruppen aufweist, von denen im Sperrzustand des Leistungsschalters (S1, S2) jeweils wenigstens eine/r sperrt,
**dadurch gekennzeichnet,**
**dass** jedem Transistor (Q1, Q2) oder jeder Transistorgruppe wenigstens eine Diode (DT1, DT2) zur Erfassung der Chiptemperatur (T1ist, T2ist) zugeordnet ist,
**dass** eine Ladungspumpe (LP) zum Erzeugen der Steuerspannung (Vst) vorgesehen ist, mittels welcher die Transistoren (Q1, Q2) des Leistungsschalters (S1, S2) jeweils nur soweit leitend gesteuert werden, dass die Chiptemperatur (T1ist, T2ist) jedes Transistors (Q1, Q2) des Leistungsschalters (S1, S2) eine vorgegebene Solltemperatur (Tsoll) beibehält, und
**dass** eine Temperatur-Erfassungseinheit vorgesehen ist, in welcher der Vergleich der Chiptemperaturen mit dem Sollwert durchgeführt wird, und welche ein diesem Vergleich zugeordnetes Steuersignal (En) für die Ladungspumpe (LP) liefert, wobei bei Erreichen der Solltemperatur (Tsoll) der Widerstand der Schaltstrecke (E-A) erhöht wird.

3. Vorrichtung nach Anspruch 2, **dadurch gekennzeichnet, dass** dem Transfer-Gate (S1, S2, TG) ein Transistor (Q3) zugeordnet ist,
dessen Kollektor-Emitterstrecke zwischen den miteinander verbundenen Gateanschlüssen (g) und den miteinander verbundenen Sourceanschlüssen (s) der zwei in Reihe geschalteten Transistoren (Q1, Q2) oder Transistorgruppen angeordnet ist, und
welcher mittels eines externen Signals (Dis) in den Leitzustand versetzbar ist, um das Transfer-Gate (TG) rasch nichtleitend zu steuern.

4. Vorrichtung nach Anspruch 2 oder 3, **dadurch gekennzeichnet,**
**dass** die Temperatur-Erfassungseinheit wenigstens eine für jeden Transistor (Q1, Q2) oder jede Transistorgruppe an den Polen (+5V, GND) einer Spannungsquelle liegende Reihenschaltung aus der ihm zugeordneten Diode (DT1, DT2) und einem Widerstand (R7, R8) aufweist,
**dass** der Verbindungspunkt zwischen Widerstand (R7, R8) und Diode (DT1, DT2), an welchem eine der Chiptemperatur (T1ist, T2ist) zugeordnete Spannung (VT1ist, VT2ist) abgreifbar ist, jeweils mit einem Eingang eines Komparators (K1, K2) verbunden ist,
**dass** an einem anderen Eingang des Komparators (K1, K2) eine der vorgegebenen Solltemperatur (Tsoll) zugeordnete Sollspannung (VTsoll) angelegt ist,
**dass** der Komparator (K1, K2) den Vergleich der der Chiptemperatur (T1ist, T2ist) zugeordneten Spannung (VT1ist, VT2ist) mit der der vorgegebenen Solltemperatur (Tsoll) zugeordneten Sollspannung (VTsoll) durchführt,
**dass** die Ausgänge aller Komparatoren (K1, K2) mit den Eingängen eines ersten Logik-Gliedes (NAND) verbunden sind,
**dass** der Ausgang des ersten Logik -Gliedes (NAND) mit einem Eingang eines zweiten Logik-Gliedes (NOR) verbunden ist, dessen anderem Eingang ein ON/OFF-Signal (Dis) zugeführt wird, und
**dass** das Ausgangssignal des zweiten Logik-Gliedes (NOR) dem Gatteroszillator (U1 bis U4) der Ladungspumpe (LP) als Steuersignal (En) zugeführt wird.

## Claims

1. Method for switching a semiconductor circuit breaker (S1, S2),
**characterised in that**
the resistance of the breaker gap (E-A) of the semiconductor circuit breaker (S1, S2) is controlled via a control input (s, g) by a control voltage (Vst) and/or a control current depending on the chip temperature (T1ist, T2ist) to such an extent that the chip temperature (T1ist, T2ist) of the circuit breaker (S1, S2) is kept at a predetermined nominal temperature (Tsoll), in which case, when the nominal temperature (Tsoll) is reached, the resistance of the breaker gap (E-A) is increased.

2. Device for implementing the method according to claim 1, especially for actuating a semiconductor circuit breaker (S1, S2) arranged between two energy storage devices (C1, DLC, B36) in a wiring system of the vehicle equipped with an integrated starter generator (ISG),
in which the circuit breaker (S1, S2) which can be controlled by means of a control voltage (Vst) so that it conducts or does not conduct is embodied as a transfer gate (TG)
- which features two transistors (Q1, Q2) or groups of transistors connected in series of which, in the off-state of the circuit breaker (S1, S2), at least one is blocked, and
**characterised in that**
each transistor (Q1, Q2) or each group of transistors is assigned at least one diode (DT1, DT2) for detecting the chip temperature (T1ist, T2ist),
for generating the control voltage (Vst), a charge pump (LP) is provided by means of which the transistors (Q1, Q2) of the circuit breaker (S1, S2), in the conductive state, are in each case only controlled to such an extent that the chip temperature (T1ist, T2ist) of each transistor (Q1, Q2) of the circuit breaker (S1, S2) is kept to a predetermined required temperature (Tsoll), and
a temperature detection unit is provided in which the comparison of the chip temperatures with the required value is undertaken, and which delivers an enable signal (En) assigned to this comparison for the charge pump (LP), with the resistance of the breaker gap (E-A) being increased when the required temperature is reached.

3. Device according to claim 2, **characterized in that** a transistor (Q3) is assigned to the transfer gate (S1, S2, TG), of which the collector-emitter path is arranged between the interconnected gate connections (g) and the interconnected source connections (s) of two transistors (Q1, Q2) or groups of transistors connected in series, and
which can be shifted by means of an external signal (Dis) to the conductive state in order to rapidly make the transfer gate (TG) non-conductive.

4. Device according to claim 2 or 3, **characterized in that** the temperature detection unit features at least one series circuit at the poles (+5v, GND) of a voltage source, consisting of the diode (DT1, DT2) assigned to it and a resistor (R7, R8) for each transistor (Q1, Q2) or for each group of transistors,
the connection point between resistor (R7, R8) and diode (DT1, DT2) at which a voltage (VT1ist, VT2ist) assigned to the chip temperature (T1ist, T2ist) can be tapped, is connected in each case to the input of a comparator (K1, K2),
at another input of the comparator (K1, K2) a nominal voltage (VTsoll) assigned to the predetermined nominal temperature (Tsoll) is applied,
the comparator (K1, K2) performs the comparison of the voltage (VT1ist, VT2ist) assigned to the chip temperature (T1ist, T2ist) with the nominal voltage (VTsoll) assigned to the predetermined nominal temperature (Tsoll),
the outputs of all comparators (K1, K2) are connected to the inputs of a first logic element (NAND),
the output of the first logic element (NAND) is connected to the input of a second logic element (NOR) of which an ON/OFF signal (Dis) is fed to the other input, and
the output signal of the second logic element (NOR) is fed to the gate oscillator (U1 to U4) of the charge pump (LP) as an enable signal (En).

## Revendications

1. Procédé de commutation d'un disjoncteur (S1, S2) à semi-conducteur,
**caractérisé**
**en ce que** l'on régule la résistance de la section (E-A) de commutation du disjoncteur (S1, S2) à semi-conducteur par une entrée (s, g) de commande au moyen d'une tension (Vst) de commande et/ou d'un courant de commande en fonction de la température (T1ist, T2ist) de puce de façon à ce que la température (T1ist, T2ist) de puce du disjoncteur (S1, S2) conserve une température (Tsoll) de consigne prescrite, la résistance de la section (E-A) de commutation étant augmentée lorsque la température (Tsoll) de consigne est atteinte.

2. Dispositif pour la mise en oeuvre du procédé suivant la revendication 1, notamment pour commuter un disjoncteur (S1, S2) à semi-conducteur monté entre deux accumulateurs (C1, DLC, B36) d'énergie dans un réseau de bord de véhicule automobile équipé d'un démarreur-générateur intégré (ISG), dans lequel le disjoncteur (S1, S2) pouvant être commandé de manière à être conducteur ou à ne pas l'être au moyen d'une tension (Vst) de commande est constitué en porte (TG) de transfert,
- qui a deux transistors (Q1, Q2) ou groupes de transistors montés en série, dont, lorsque le disjoncteur (S1, S2) est à l'état bloqué, au moins un bloque,
**caractérisé**
**en ce qu'**à chaque transistor (Q1, Q2) ou à chaque groupe de transistors est associée au moins une diode (DT1, DT2) de détection de la température (T1ist, T2ist) de puce,
**en ce qu**'il est prévu une pompe (LP) de charge pour produire la tension (Vst) de commande, au moyen de laquelle les transistors (Q1, Q2) du disjoncteur (S1, S2) sont commandés respectivement, de manière à n'être passants que tant que la température (T1ist, T2ist) de puce de chaque transistor (Q1, Q2) du disjoncteur (S1, S2) conserve une température (Tsoll) de consigne prescrite et
**en ce qu**'il est prévu une unité de détection de la température dans laquelle est effectuée la comparaison des températures de puce à la valeur de consigne et qui fournit un signal (En) de commande associé à cette comparaison pour la pompe (LP) de charge, la résistance de la section (E-A) de commutation étant augmentée lorsque la température (Tsoll) de consigne est atteinte.

3. Dispositif suivant la revendication 2, **caractérisé en ce que**, à la porte (S1, S2, TG) de transfert est associé à un transistor (Q3),
dont la section de collecteur-émetteur est disposée entre les bornes (g) de grille reliées entre elles et les bornes (s) de source reliées entre elles des deux transistors (Q1, Q2) ou groupes de transistors montés en série et
qui peut être mise à l'état conducteur au oyent d'un signal (Dis) extérieur pour faire passer rapidement à l'état non conducteur la porte (TG) de transfert.

4. Dispositif suivant la revendication 2 ou 3, **caractérisé en ce que**
l'unité de détection de température a au moins un circuit série se trouvant pour chaque transistor (Q1, Q2) ou chaque groupe de transistors aux pôles (+5V, GND) d'une source de tension est constituée de la diode (DT1, DT2) qui lui est associée et d'une résistance (R7, R8),
**en ce que** le point de liaison entre la résistance (R7, R8) et la diode (DT1, DT2) auquel une tension (VT1ist, VT2ist) associée à la température (T1ist, T2ist) de puce peut être prélevée est relié respectivement à une entrée d'un comparateur (K1, K2),
**en ce que** sur une autre entrée du comparateur (K1, K2) est appliquée une tension (VTsoll) de consigne associée à la température (Tsoll) de consigne prescrite,
**en ce que** le comparateur (K1, K2) effectue la comparaison de la tension (VT1ist, VT2ist) associée à la température (T1ist, T2ist) de puce à la tension (VTsoll) de consigne associée à la température (Tsoll) de consigne prescrite,
**en ce que** les sorties de tous les comparateurs (K1, K2) sont reliées aux entrées d'un premier élément logique (NAND),
**en ce que** la sortie du premier élément logique (NAND) est reliée à une entrée d'un deuxième élément logique (NOR) à l'autre entrée duquel est envoyé un signal ON/OFF (Dis), et
**en ce que** le signal de sortie du deuxième élément logique (NOR) est envoyé à l'oscillateur (U1 à U4) de porte de la pompe (LP) de charge en tant que signal (En) de commande.
